# EUROPEAN PATENT SPECIFICATION

(11) **EP 4 044 432 B1**
(45) Date of publication and mention of the grant of the patent: **01.04.2026**
(21) Application number: 20864907.9
(22) Date of filing: 24.04.2020
(51) Int. Cl.: H03H 9/10, H03H 9/05, H03H 9/56

(54) **SEMICONDUCTOR DEVICE HAVING CONDUCTIVE VIA OFFSET STRUCTURE, POWER SUPPLY STRUCTURE, AND ELECTRONIC DEVICE**
HALBLEITERBAUELEMENT MIT LEITENDER DURCHKONTAKTIERUNGSVERSATZSTRUKTUR, STROMVERSORGUNGSSTRUKTUR UND ELEKTRONISCHE VORRICHTUNG
DISPOSITIF À SEMI-CONDUCTEUR AYANT UNE STRUCTURE DE DÉCALAGE DE TROU D'INTERCONNEXION CONDUCTRICE, STRUCTURE D'ALIMENTATION ÉLECTRIQUE, ET DISPOSITIF ÉLECTRONIQUE

(30) Priority: 20.09.2019 CN 201910890692
(43) Date of publication of application: 17.08.2022
(73) Proprietor: Tianjin University, Tianjin 300072 (CN)
(72) Inventor: YANG, Qingrui, Tianjin 300072 (CN); PANG, Wei, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/086560
(87) International publication number: WO 2021/051811

(56) References cited:
- CN-A- 101 009 482
- CN-A- 102 545 828
- CN-A- 102 823 131
- CN-A- 108 292 914
- US-A- 6 114 240
- US-A1- 2006 012 021
- US-A1- 2007 115 079
- US-A1- 2007 170 565
- US-A1- 2008 266 023
- US-A1- 2012 049 978

## Description

### TECHNICAL FIELD

Embodiments of the present disclosure relate to the field of semiconductors, and in particular, to a semiconductor device, a power supply structure of a semiconductor device, and an electronic device having the semiconductor device or the power supply structure.

### BACKGROUND

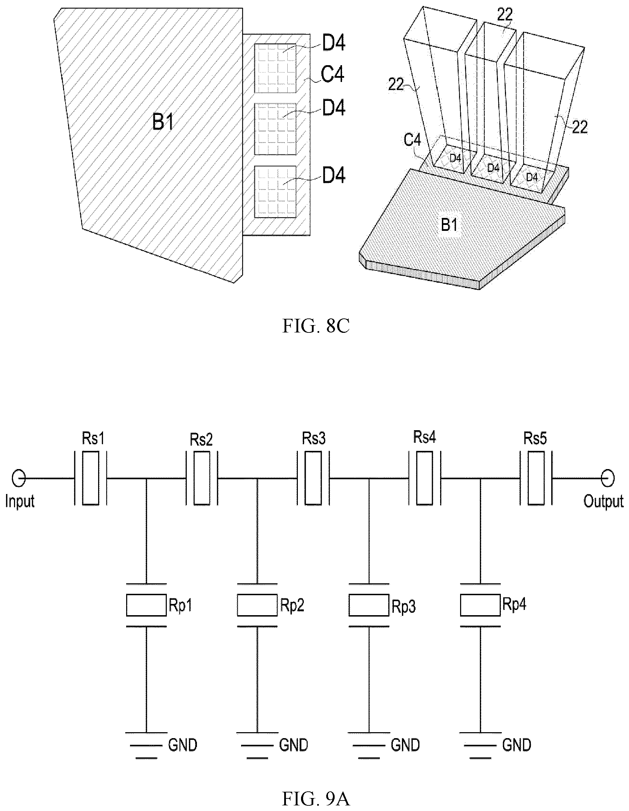

FIG. 9A is an abstract circuit diagram of a filter with bulk acoustic wave resonators. The resonators includes five series resonators Rs1-5 and four parallel resonators Rp1-4. In addition, the filter further includes an input terminal Input, an output terminal Output, and four ground terminals GND.

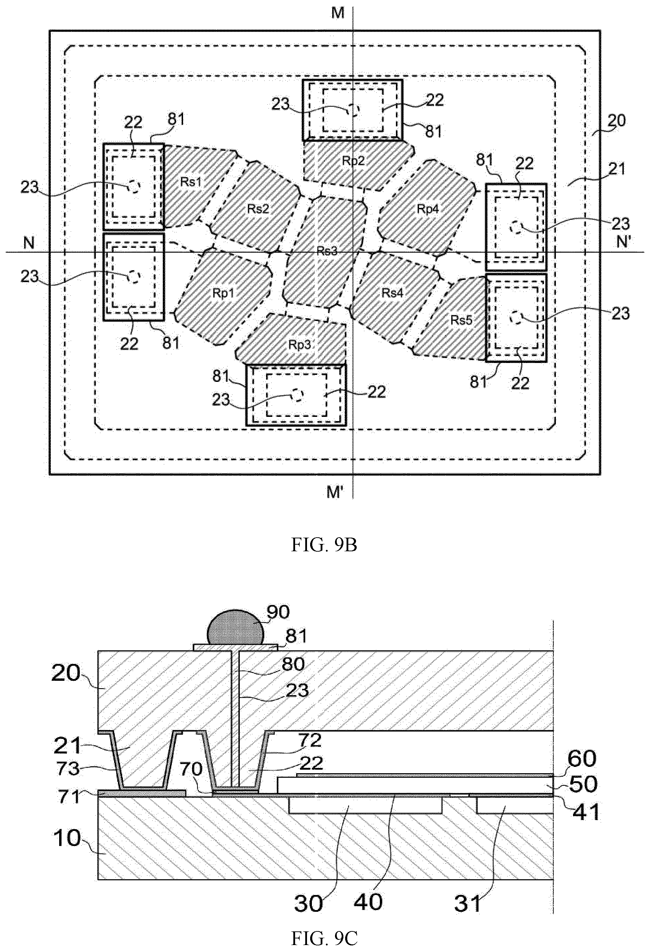

FIG. 9B is a top view of a conventional packaging structure of the filter shown in FIG. 9A. FIG. 9C is a sectional view of the packaging structure along line M-M' in FIG. 9B, and shows a part of the packaging structure above a line N-N' in FIG. 9B.

The packaging structure shown in FIGS. 9B and 9C includes:
a first substrate 10 configured to carry an acoustic device and package a bonding layer, and the first substrate being made of a material selected from monocrystalline silicon, gallium arsenide, quartz, sapphire or the like;
a second substrate 20 configured to carry the bonding layer, pads, and solder balls, and the second substrate being provided with a via structure therein;
a first protrusion 21 configured to provide an attachment surface for the bonding layer, a cavity being provided in a packaging structure formed by the first substrate 10 and the second substrate 20 by means of the first protrusion, and the first protrusion being an annular protrusion;
second protrusions 22 configured to provide an attachment surface for a conductor metal, the second protrusion each further including a via, a part of which is configured to accommodate the conductor metal;
vias 23 configured to be filled with the conductor metal;
an acoustic mirror 30 being an air cavity in this example, the acoustic mirror additionally be a Bragg reflection layer or other similar acoustic wave reflection structures;
lower electrodes (bottom electrodes) 40, 41 made of a material selected from at least one of molybdenum, ruthenium, gold, aluminum, magnesium, tungsten, copper, titanium, iridium, osmium, chromium, or composite or alloy thereof;
a piezoelectric layer film 50 made of a material selected from aluminum nitride, zinc oxide, PZT, or a rare earth element doped material thereof;
an upper electrode (a top electrode) 60 made of the same material as the lower electrodes 40, 41;
conductor layer metals 70, 72 mainly made of gold or the like;
bonding layer metals 71, 73 mainly made of gold or the like;
a conductor metal 80 located in the via and mainly made of copper, and the conductor metal being configured to connect the pad and the conductor layers 70, 72;
the pads 81 configured to carry the solder balls; and
the solder balls 90 mainly made of tin or indium.

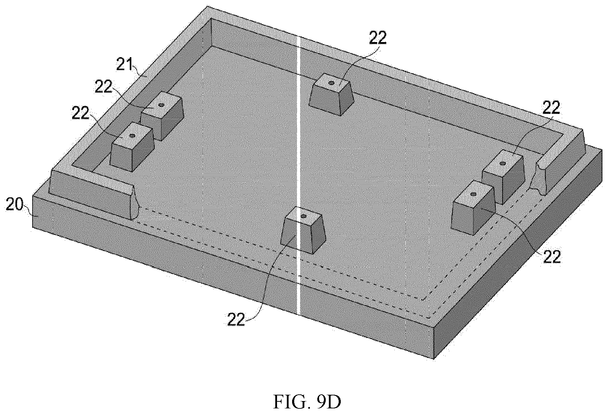

In addition, FIG. 9D also shows a perspective view of the second substrate 20 (including the first protrusion 21 and the second protrusions 22 located thereon).

Since the second protrusions in the conventional structure each have a via such that the second protrusions cannot be further reduced in dimension. Hence, the packaging structure is hardly decreased in dimension in a lateral direction.

US 2007/170565 A1 relates to the manufacturing of an RF module using the bonding of three substrates.

US 2012/049978 A1 relates to an integrated wafer level package with first and second wafers faced with each other and a seal ring joining both wafers.

### SUMMARY

The present disclosure is provided to offset a via in a second substrate towards an inner side to reduce a dimension of a second protrusion, so that a packaging structure can be reduced in dimension in a lateral direction.

According to one aspect of embodiments of the present disclosure, there is provided a semiconductor device according to claim 1.

Alternatively, the semiconductor device further includes a bonding layer arranged on a surface of the annular support protrusion. The bonding layer is electrically isolated from the conductor layer.

Alternatively, the at least one second protrusion includes a plurality of second protrusions spaced apart from each other, and at least one of the plurality of second protrusions is integrally formed with the annular support protrusion.

Alternatively, at least one pin corresponding to the at least one second protrusion has an L-shaped contact surface, the L-shaped contact surface has a shortest side with a length not greater than 50 µm, and all sides of the L-shaped contact surface have lengths not less than 5 µm.

Alternatively, at least one pin corresponding to the at least one second protrusion has a rectangular contact surface, the rectangular contact surface has a shortest side with a length not greater than 50 µm, and all sides of the rectangular contact surface have lengths not less than 5 µm. Alternatively, at least one of the at least one second protrusion includes a plurality of sub-protrusions spaced apart from each other.

Alternatively, the semiconductor device further includes a pad and a solder ball arranged on a second side of the second substrate and electrically connected to each other. The pad is electrically connected to the conductive via.

Alternatively, the conductive via passes throughout the second substrate in a thickness of the second substrate.

Alternatively, a protective layer is provided at a side or sides where either or both ends of the conductive via are located.

Alternatively, a stepped portion is provided on the inclined sidewalls.

Alternatively, a protective layer is provided at a side where a lower end of the conductive via is located.

Alternatively, the solder ball is located within the recessed portion.

Alternatively, the recessed portion has a depth greater than half of a thickness of the second substrate.

Alternatively, the semiconductor device is a filter. The semiconductor element includes at least one bulk acoustic wave resonator. The at least one bulk acoustic wave resonator includes a bottom electrode, a piezoelectric layer, and a top electrode, and an electrode of a corresponding one of the at least one bulk acoustic wave resonator is electrically connected to the pin.

According to a still another aspect of the present disclosure, there is provided a method for manufacturing a semiconductor device according to claim 11.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1 is a schematic partial sectional view of a packaging structure with an offset conductive via according to an exemplary embodiment of the present disclosure;
FIG. 2 is a schematic partial sectional view of a packaging structure with an offset conductive via according to an exemplary embodiment of the present disclosure, in which a second protrusion is integrally formed with a corresponding annular support protrusion;
FIG. 3A is a schematic partial sectional view of a packaging structure with an offset conductive via according to an exemplary embodiment of the present disclosure, in which a second protrusion and an annular support protrusion corresponding to each other are radially spaced apart from each other;
FIG. 3B is a schematic partial sectional view of a packaging structure with an offset conductive via according to an exemplary embodiment of the present disclosure, in which a second protrusion and an annular support protrusion corresponding to each other are radially spaced apart from each other, and the conductive via is provided with protective layers arranged at upper and lower ends thereof;
FIG. 4 is a schematic partial sectional view of a packaging structure with an offset conductive via according to an exemplary embodiment of the present disclosure, in which a second protrusion and annular support protrusions corresponding to each other are radially spaced apart from each other, the conductive via is provided with a protective layer arranged at an upper end thereof and a recessed portion arranged at a lower end thereof;

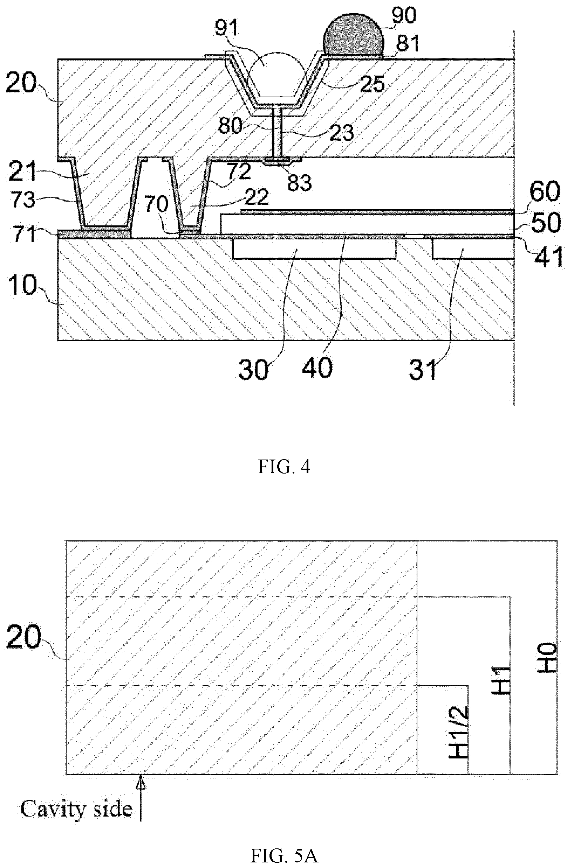

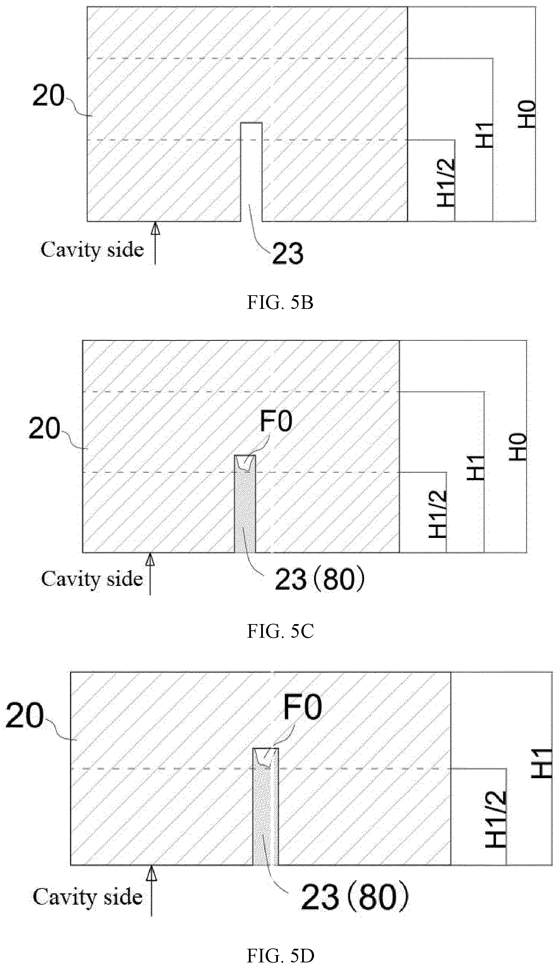

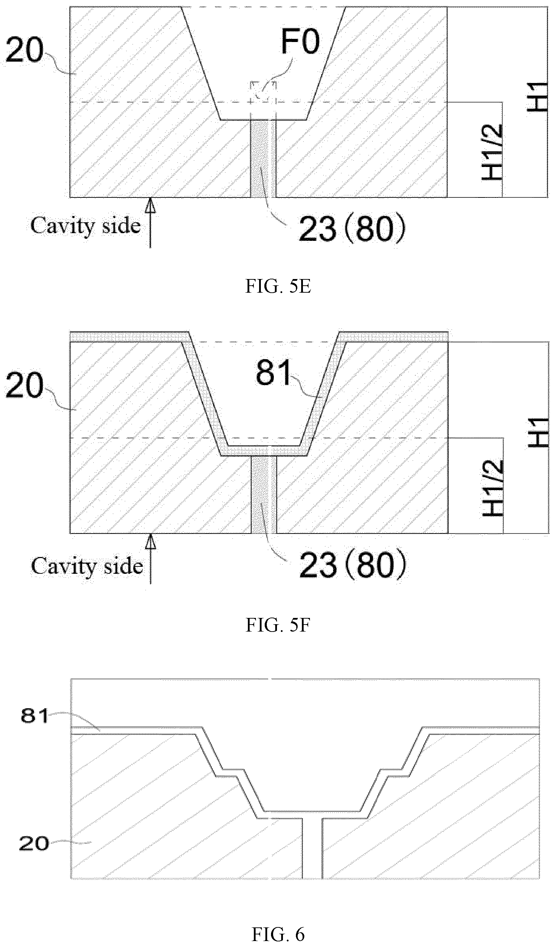

FIGS. 5A to 5F schematically show process steps of forming a conductive via with a recessed portion at an upper portion thereof on a substrate, in which FIG. 5A schematically shows a pre-grinding thickness, a target grinding thickness, and a half-target thickness of a packaged wafer, FIG. 5B shows a step of forming a blind hole on a cavity side of the substrate, FIG. 5C shows a step of filling the blind hole with a conductor metal, FIG. 5D shows a step of grinding and processing an opposite side of the substrate opposite to the cavity side to achieve the target thickness, FIG. 5E shows a step of processing a cavity on the opposite side of the substrate, and FIG. 5F shows a step of depositing a metal layer within the cavity;
FIG 6 is a schematic view of a recessed portion at an upper portion of a conductive via, in which the recessed portion has a funnel-shaped structure;
FIG. 7 is two sectional views of a conductive via according to an exemplary embodiment of the present disclosure;
FIG. 8A is a schematic view of a shape of a second protrusion according to an exemplary embodiment of the present disclosure;
FIG. 8B is a schematic view of a shape of a second protrusion according to another exemplary embodiment of the present disclosure;
FIG. 8C is a schematic view of a shape of a second protrusion according to a further another embodiment of the present disclosure.
FIG. 9A is an abstract circuit diagram of a filter with a bulk acoustic wave resonator in the related art;
FIG. 9B is a top view of a conventional packaging structure of the filter shown in FIG. 9A;
FIG. 9C is a sectional view of the packaging structure along line M-M' in FIG. 9B, and illustrates a part of the packaging structure above line N-N' shown in FIG. 9B; and
FIG. 9D is a schematic perspective view of a second substrate.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

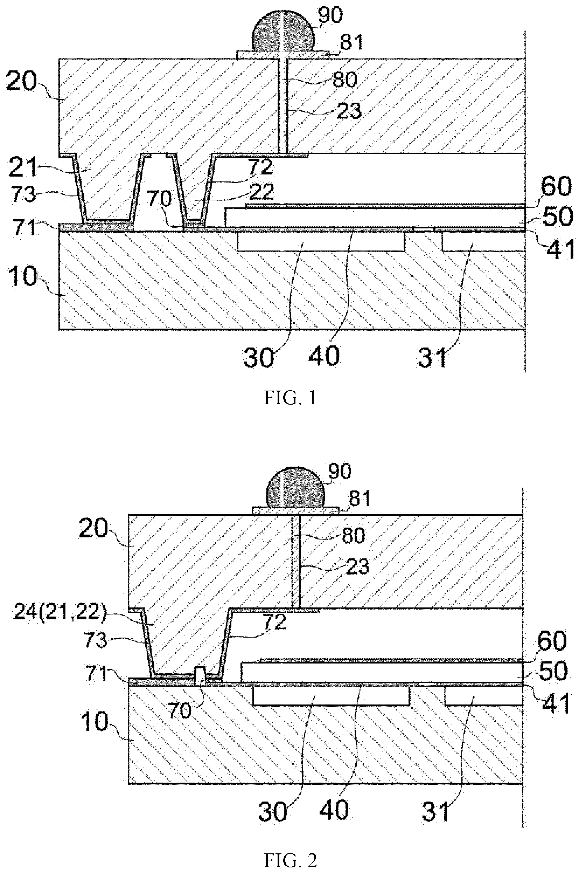

FIG. 1 is a schematic partial sectional view of a packaging structure with an offset conductive via according to an exemplary embodiment A100 of the present disclosure.

As shown in FIG. 1, the packaging structure includes:
a first substrate 10 configured to carry an acoustic device and package a bonding layer, the first substrate 10 being made of a material selected from monocrystalline silicon, gallium arsenide, quartz, sapphire or the like, and the first substrate having a thickness in a range of 10 µm to 1000 µm;
a second substrate 20 configured to carry the bonding layer, a pad, and a solder ball, the second substrate 20 being provided with a via structure formed therein, and the second substrate having a thickness in a range of 10 µm to 1000 µm;
a first protrusion 21 configured to provide an attachment surface for the bonding layer, a cavity being provided in a packaging structure formed by the first substrate 10 and the second substrate 20 through the first protrusion, and the first protrusion being an annular protrusion and having a height in a range of 3 µm to 50 µm;
a second protrusion 22 configured to provide an attachment surface for a conductor metal, the second protrusion further including a conductive via, a part of which is configured to accommodate the conductor metal;
the conductive via 23 configured to be filled with the conductor metal;
an acoustic mirror 30 which is an air cavity in this embodiment, or the acoustic mirror being a Bragg reflection layer or other similar acoustic wave reflection structures;
lower electrodes (bottom electrodes) 40, 41 made of a material selected from at least one of molybdenum, ruthenium, gold, aluminum, magnesium, tungsten, copper, titanium, iridium, osmium, chromium, or composite or alloy thereof;
a piezoelectric layer film 50 made of a material selected from aluminum nitride, zinc oxide, PZT, or a rare earth element doped material thereof;
an upper electrode (a top electrode) 60 made of the same material as the lower electrodes 40, 41;
conductor layer metals 70, 72 mainly made of gold or the like, in which the conductor layer metal may be a single-layer metal or a composite structure of multilayer metal in this embodiment of the present disclosure;
bonding layer metals 71, 73 mainly made of gold or the like and having a thickness in a range of 0.5 µm to 2 µm;
a conductor metal 80 located in the conductive via and mainly made of copper, and the conductor metal 80 being configured to connect the pad and the conductor layers 70,72;
the pad 81 configured to carry the solder ball; and
the solder ball 90 mainly made of tin or indium.

As shown in FIG. 1, the conductive via 23 is arranged to be spaced from the second protrusion 22, rather than being arranged therein. In this way, the conductive via 23, the pad 81 and the solder ball 90 are translated towards a resonator side. Meanwhile, the conductor layer 72 also extends towards the resonator side along a lower surface of the substrate 20. Since the second protrusion 22 is not provided with a conductive via therein in this case, the second protrusion 22 has a lateral dimension which is significantly reduced, such that the first protrusion 21 is translated inwardly. Therefore, the packaging structure has a smaller lateral dimension than that of the conventional packaging structure.

Based on the structure shown in FIG. 1, in a top view of the packaging structure, the conductive via 23 is located at an inner side of the second protrusion 22 or is spaced apart from the second protrusion 22. Alternatively, the conductive via 23 does not coincide with a corresponding pin, such as a pin C3 in FIG. 5.

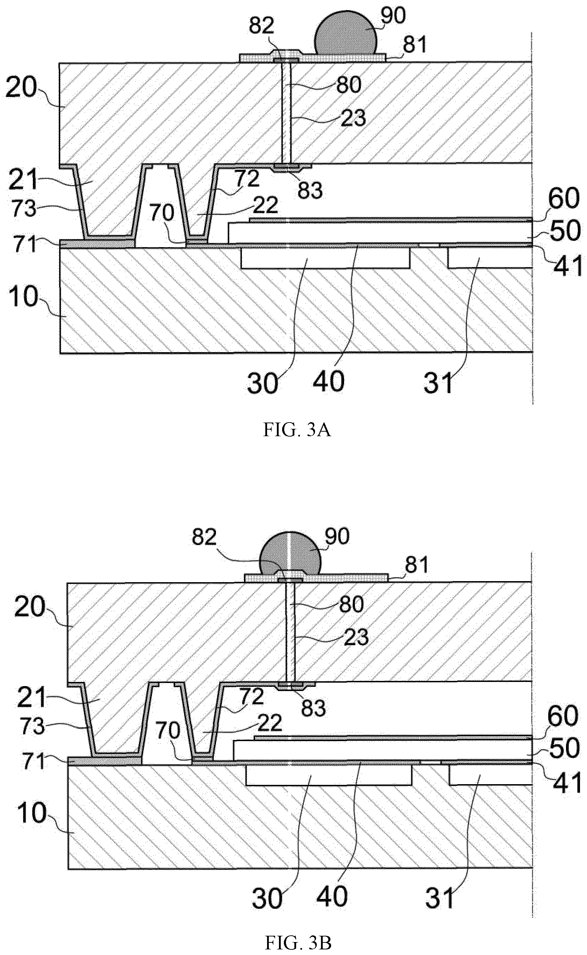

FIG. 2 is a schematic partial sectional view of a packaging structure with an offset conductive via according to another exemplary embodiment A200 of the present disclosure. As shown in FIG. 2, the first protrusion 21 moves further inwardly, and is combined with the second protrusion 22 to integrally form a protrusion 24. Meanwhile, the conductor layer 72 is ensured to be spaced apart from the bonding layer 73 by a predetermined gap, i.e., an electrical isolation, thereby forming the structure shown in FIG. 2. Compared to the packaging structure shown in FIG. 1, the packaging structure shown in FIG. 2 has a lateral dimension which is further reduced. As shown in FIG. 2, the bonding layer 73 is arranged at a left side of an end surface of the protrusion 24, the conductor layer 72 is arranged at a right side of an end surface of the protrusion 24, and the bonding layer 73 is electrically isolated from the conductor layer 72. In embodiments shown in FIGS. 3A and 3B, the conductive via 23 is provided with a protective layer or protection layer(s) 82/83 arranged at an upper end and/or a lower end thereof. The protective layer 82/83 is a protective layer configured to prevent moisture from entering the conductive via 23. Further, in addition to the position shown in FIGS. 3A and 3B, the protective layer 82 may be located above the pad 81, and the protective layer 83 may be located below the conductor layer 72. The protective layer may be made of a metal such as chromium, gold, titanium in a case of electrical conduction, or may be made of a non-metal such as silicon dioxide, silicon carbide, aluminum oxide, aluminum nitride, or other dielectric materials without the electrical conduction.

In an embodiment shown in FIG. 4, a protective layer is provided at the lower end of the conductive via.

In the embodiment shown in FIG. 4, a solder ball 91 is provided within a recessed portion formed at the upper end of the conductive via, or the solder ball 90 is moved to a position of the solder ball 91, which can also function as the protective layer.

The protective layer or the protection layer can enhance sealing performance of the conductive via.

In the embodiments of the present disclosure, the protective layer may have the same coating area as that of the conductor layer, or the protective layer may have a different coating area from that of the conductor layer, which is not limited thereto.

In the conventional packaging structure shown in FIG. 9C, the conductive via 23 is blocked at an end of a bonding interface and thus blocked by the conductor layer, the lower electrode located below the conductor layer, and the first substrate. Accordingly, the conductor metal 80 filled in the conductive via 23 cannot leak out. However, in the packaging structures shown in the embodiment A100 of FIG. 1 and the embodiment A200 of FIG. 2, since only one layer of the conductor metal or conductor layer 72 is arranged at an opening of the conductive via 23 at the lower surface of the second substrate 20, the conductor metal 80 filled in the conductive via 23 may not being blocked by the conductor layer 72, which may result in leakage. In addition, in the embodiments shown in FIGS. 1, 2, 3A and 3B, since passing throughout the second substrate 20, the conductive via 23 has a relatively long length, which tends to generate a filling defect during filling the conductor metal 80 into the conductive via 23. Accordingly, an impedance of the conductor becomes large or even generates a break, thereby significantly affecting performance and yield of a filter or other electronic devices.

In order to solve this problem, in a further embodiment of the present disclosure, a funnel-shaped via structure is provided in the packaging structure of the embodiment A100 shown in FIG. 1 or embodiment A200 shown in FIG. 2. Referring to FIG 4, the funnel-shaped via structure is formed with a horizontal bottom portion and inclined sidewalls in a region 25 to increase a contact area of the conductor metal 80 and the second substrate 20, thereby increasing the attachment stability of the conductor metal 80.

In addition, some modification may be made to the funnel-shaped via structure in the embodiment shown in FIG. 4. As shown in FIG. 6, the funnel-shaped via structure is additionally provided with a stepped structure on sidewalls thereof, respectively, to further increase the contact area of the metal layer or conductor layer and the second substrate 20.

A method for manufacturing the via structure with the recessed portion shown in FIG. 4 is illustratively described below with reference to FIGS. 5A to 5E.

FIG. 5A schematically shows a pre-grinding thickness H0, a target grinding thickness H1, and a half-target thickness H1/2 of a packaged wafer.

FIG 5B shows a step of forming a blind hole on a cavity side of the second substrate. The blind hole 23 is formed on the cavity side of the second substrate 20 through deep silicon etching (DSI) or other processes, and the blind hole has a depth not less than H1/2.

FIG. 5C shows a step of filling the blind hole with the conductor metal. In FIG. 5C, the blind hole 23 is filled with the conductor metal 80 by processes such as sputtering and electroplating. A filling defect F0 is generally formed at a blind end of the blind hole 23.

FIG. 5D shows a step of grinding and processing an opposite side opposite to the cavity side of the second substrate to achieve the target thickness H1.

FIG. 5E shows a step of processing a cavity on the opposite side opposite to the cavity side of the second substrate. Specifically, the opposite side of the second substrate 20 is etched to form a trapezoidal hole with a depth greater than H1/2, and the metal filling defect F0 containing a small section of the conductor metal 80 therebelow is also removed during the etching. Meanwhile, the blind hole 23 is formed to be a through hole, and there is no meal filling defect in the remaining section of the conductor metal.

FIG. 5F shows a step of depositing a metal layer within the cavity. A metal layer 81 is deposited additionally on a surface of the opposite side opposite to the cavity side of the second substrate 20 and an inner surface of the trapezoidal hole. The trapezoidal hole has inclined sidewalls and a bottom portion and the bottom portion has a diameter granter than the opening of the conductive via 23. In this way, a good contact of the metal layer 81 and the conductive via 23 can be ensured, and the metal layer 81 can be uniformly deposited on the inner surface of the trapezoidal hole.

In the exemplary embodiment of the present disclosure, the target grinding thickness H1 is in a range of 20 µm to 300 µm, each of the protrusions 21 and 22 has a height in a range of 3 µm to 50 µm, and each of the bonding layers 71, 73 and the conductor layers 70, 72 has a thickness in a range of 0.5 µm to 2 µm.

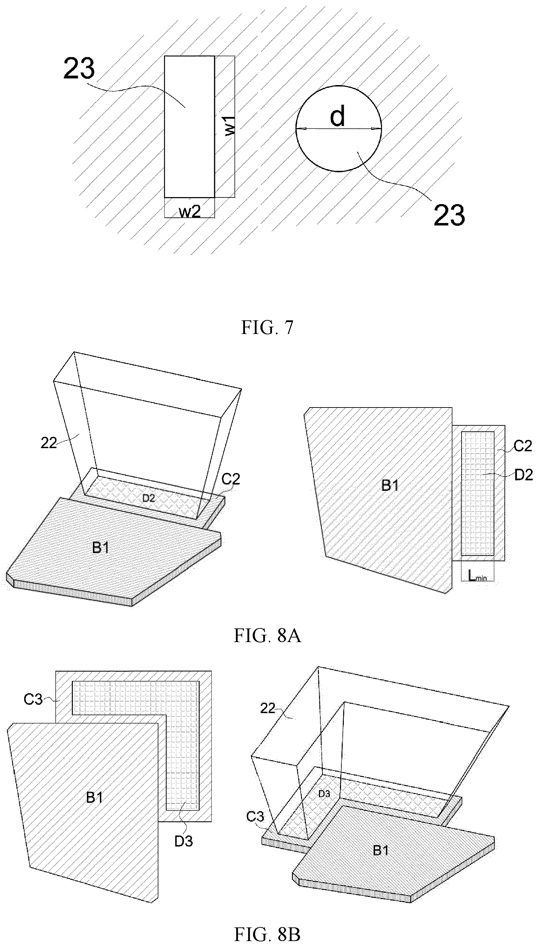

FIG. 7 illustrates two sectional views of a conductive via according to an exemplary embodiment of the present disclosure. As shown in FIG. 7, the conductive via 23 has a rectangular or circular shape or other shapes, such as a rectangle or a polygon with chamfered or rounded corners in a top view of the conductive via 23. The conductive via with a too large or too small dimension may adversely affect integrity of the metal filled thereof, and thus the dimension of the conductive via is limited. For example, the conductive via in the rectangular shape may have a shortest side with a length w2 in a range of 1 µm to 10 µm, preferably in a range of 1 µm to 3 µm, or the conductive via in the circular shape may have a diameter d in a range of 1 µm to 10 µm, preferably in a range of 1 µm to 3 µm. Further, the conductive via in the rectangular shape or a polygonal shape may have a longest side w1 with a length not greater than 50 µm.

The second protrusion 22 with the reduced dimension may have a variable shape, and thus has more freedom in position than the conventional packaging structure. FIGS. 8A to 8C illustratively show these modifications.

FIG. 8A is a schematic view showing a shape of a second protrusion according to an exemplary embodiment of the present disclosure. As shown in FIG. 8A, the second protrusion has a prism shape, and is in contact with a pin C2 by a rectangular pin contact surface D2. FIG. 8B is a schematic view showing a shape of a second protrusion according to another exemplary embodiment of the present disclosure. As shown in FIG. 8B, the second protrusion is an L-shaped prism and is in contact with the pin PC by an L-shaped pin contact surface D3. Each of the pin contact surfaces shown in FIGS. 8A and 8B has a shortest side with a length Lₘᵢₙ not greater than 50 µm, and all sides of each of the pin contact surfaces have lengths not less than 5 µm.

FIG. 8C is a schematic view showing a shape of the second protrusion according to a further another embodiment of the present disclosure. As shown in FIG. 8C, second protrusions 22 may be a plurality of sub-protrusions spaced apart from each other. In FIG. 8C, the second protrusions 22 are formed by three prisms spaced apart from each other. In this way, the conductor layer can be deposited on a surface of each of the prisms as well as between two adjacent surfaces of the prisms (i.e., in a gap between the two adjacent surfaces of the prisms), such that the impedance of the conductor is reduced by increasing an area of the conductor layer.

In the present disclosure, although a filter having a bulk acoustic wave resonator is provided to describe the semiconductor device as an example, it should be understood for those skilled in the art that the semiconductor device of the present disclosure is not limited to the filter, and all semiconductor devices with the conductive via offset structure as described in claim 1 shall fall within the scope of the present disclosure.

In the present disclosure, the conductive via is shifted such that in the top view of the semiconductor device, the conductive via is located at the inner side of the second protrusion or spaced apart from the second protrusion, or the conductive via does not coincide with an end surface of the corresponding second protrusion.

In the present disclosure, for a packaging space of the semiconductor, an inner side refers to a side close to a center of the packaging space, and an outer side refers to a side away from the center of the packaging space or away from the packaging space. Compared to the related art in which the conductive via is arranged in the protrusion (corresponding to the second protrusion in the second embodiment of the present disclosure), the conductive via is shifted towards the inner side to be spaced apart from the protrusion or located at the inner side of the protrusion in the top view in the present disclosure.

In the related art, the conductive via is arranged in the second protrusion, and the end of the second protrusion abuts against the pin, so that at least part of the conductive via coincides with the pin in the top view. However, in the present disclosure, the conductive via is arranged outside the second protrusion, so that the conductive via does not coincide with the pin or and the corresponding end surface of the second protrusion in the top view.

In the illustrated embodiment of the present disclosure, although the packaging structure is described, it should be understood for those skilled in the art that there is also provided a power supply structure for the semiconductor device with reference to the accompanying drawings of the present disclosure. The power supply structure may include the first protrusion 21 and the second protrusion 22, or may include only one protrusion, as long as the one protrusion abuts against an electrical connection portion (or an electrical connection pin of the semiconductor device) on the other side.

Although the embodiments of the present disclosure have been shown and described, it should be understood for those skilled in the art that modifications may be made to these embodiments without departing from the scope as defined by the appended claims and their equivalents.

## Claims

1. A semiconductor device, comprising:
a first substrate (10);
a second substrate (20) opposite to the first substrate (10), an accommodation space being provided between the first substrate (10) and the second substrate (20);
a semiconductor element provided in the accommodation space and arranged on the first substrate (10), the semiconductor element is provided with a pin (C2, C3) for electrical connection;
an annular support protrusion (21) provided between the first substrate (10) and the second substrate (20), the annular support protrusion (21), a first side of the first substrate (10) and a first side of the second substrate (20) defining the accommodation space;
at least one second protrusion (22) provided at an inner side of the annular support protrusion (21) and arranged within the accommodation space;
a conductor layer (70, 72) provided on a surface of the at least one second protrusion (22), the conductor layer (70, 72) comprising a first connection portion and a via connection portion electrically connected to each other, the first connection portion being arranged at an end surface of the at least one second protrusion (22) and electrically connected with the pin (C2, C3), and the via connection portion extending along the first side of the second substrate (20);
a conductive via (23) provided at the second substrate (20), the conductive via (23) being provided with a conductive material therein and being electrically connected to the via connection portion; and
a pad (81) provided on a second side of the second substrate (20) and electrically connected to the conductive via (23),
wherein in a top view of the semiconductor device, the conductive via (23) is located at an inner side of a corresponding one of the at least one second protrusion (22) or is spaced apart from a corresponding one of the at least one second protrusion (22), or the conductive via (23) does not coincide with an end surface of a corresponding one of the at least one second protrusion (22); and
wherein the second substrate (20) is provided with a recessed portion corresponding to the conductive via (23) on the second side of the second substrate (20), the recessed portion is provided with a horizontal bottom portion and inclined sidewalls, the conductive via (23) is provided with an upper end at the horizontal bottom portion, and the conductive material in the conductive via (23) is in contact with a conductive material layer of the pad (81) provided on the horizontal bottom portion and the inclined sidewalls of the recessed portion.

2. The semiconductor device according to claim 1, **characterized in that** the semiconductor device further comprises:
a bonding layer (71, 73) provided on a surface of the annular support protrusion (21), the bonding layer (71, 73) being electrically isolated from the conductor layer (70, 72).

3. The semiconductor device according to claim 1 or 2, **characterized in that** the at least one second protrusion (22) comprises a plurality of second protrusions space apart from each other, and at least one of the plurality of second protrusions is integrally formed with the annular support protrusion (21); or
at least one of the at least one second protrusion (22) comprises a plurality of sub-protrusions spaced apart from each other.

4. The semiconductor device according to claim 1 or 2, **characterized in that** at least one pin (C3) corresponding to the at least one second protrusion (22) has an L-shaped contact surface (D3), the L-shaped contact surface (D3) has a shortest side with a length not greater than 50 µm, and all sides of the L-shaped contact surface (D3) have lengths not less than 5 µm; or
at least one pin (C2) corresponding to the at least one second protrusion (22) has a rectangular contact surface (D2), the rectangular contact surface (D2) has a shortest side with a length not greater than 50 µm, and all sides of the rectangular contact surface (D2) have lengths not less than 5 µm.

5. The semiconductor device according to any one of claims 1 to 4, **characterized in that** the semiconductor device further comprises a solder ball (90) provided on the second side of the second substrate (20), and the pad (81) and the solder ball (90) are electrically connected to each other.

6. The semiconductor device according to claim 5, **characterized in that** the conductive via (23) passes throughout the second substrate (20) in a thickness direction of the second substrate (20).

7. The semiconductor device according to claim 6, **characterized in that**, a protective layer (82, 83) is provided at a side or sides of the conductive via (23) where either or both ends of the conductive via (23) are located.

8. The semiconductor device according to claim 1, **characterized in that** the inclined sidewalls are provided with a stepped portion; or
a protective layer (83) is provided at a side where a lower end of the conductive via (23) is located.

9. The semiconductor device according to claim 1, **characterized in that** the solder ball (90) is located within the recessed portion; or
the recessed portion has a depth greater than half of a thickness (H1) of the second substrate (20).

10. An electronic device, comprising the semiconductor device according to any one of claims 1 to 9.

11. A method for manufacturing a semiconductor device, comprising:
providing a first substrate (10) and a second substrate (20) opposite to each other and providing an annular support protrusion (21) between the first substrate (10) and the second substrate (20), the annular support protrusion (21), a first side of the first substrate (10) and a first side of the second substrate (20) defining an accommodation space;
providing a semiconductor element in the accommodation space, the semiconductor element being arranged on the first substrate (10) and provided with a pin (C2, C3) for electrical connection;
providing at least one second protrusion (22) within the accommodation space, the at least one second protrusion (22) being arranged at an inner side of the annular support protrusion (21);
providing a conductor layer (70, 72) on a surface of the at least one second protrusion (22), the conductor layer (70, 72) comprising a first connection portion and a via connection portion electrically connected to each other, the first connection portion being arranged at an end surface of the at least one second protrusion (22) and electrically connected with the pin (C2, C3), and the via connection portion extending along the first side of the second substrate (20); and
providing a conductive via (23) at the second substrate (20), the conductive via (23) being provided with a conductive material therein and electrically connected to the via connection portion,
wherein in a top view of the semiconductor device, the conductive via (23) is located at an inner side of a corresponding one of the at least one second protrusion (22) or is spaced apart from a corresponding one of the at least one second protrusion (22), or the conductive via (23) does not coincide with an end surface of a corresponding one of the at least one second protrusion (22); and
wherein the providing the conductive via (23) in the second substrate (20) comprises:
processing a blind hole on the first side of the second substrate (20), the blind hole having a depth not less than half of a thickness (H1) of the second substrate (20);
filling the conductive material in the blind hole;
processing a recessed portion on a second side of the second substrate (20), the recessed portion having a depth not less than half of the thickness (H1) of the second substrate (20), and the second side of the second substrate (20) being opposite to the first side of the second substrate (20); and
providing a conductive material layer within the recessed portion, the conductive material layer being electrically connected to the conductive material in the blind hole.

## Patentansprüche

1. Halbleitervorrichtung, umfassend:
ein erstes Substrat (10);
ein zweites Substrat (20) gegenüber dem ersten Substrat (10), wobei zwischen dem ersten Substrat (10) und dem zweiten Substrat (20) ein Aufnahmeraum vorgesehen ist;
ein Halbleiterelement, das Halbleiterelement in dem Aufnahmeraum vorgesehen und auf dem ersten Substrat (10) angeordnet ist, wobei das Halbleiterelement mit einem Pin (C2, C3) für eine elektrische Verbindung versehen ist;
einen ringförmigen Stützvorsprung (21), der zwischen dem ersten Substrat (10) und dem zweiten Substrat (20) vorgesehen ist, wobei der ringförmige Stützvorsprung (21), eine erste Seite des ersten Substrats (10) und eine erste Seite des zweiten Substrats (20) den Aufnahmeraum definieren;
mindestens einen zweiten Vorsprung (22), der an einer Innenseite des ringförmigen Stützvorsprungs (21) vorgesehen und innerhalb des Aufnahmeraums angeordnet ist;
eine Leiterschicht (70, 72), die auf einer Oberfläche des mindestens einen zweiten Vorsprungs (22) vorgesehen ist, wobei die Leiterschicht (70, 72) einen ersten Verbindungsabschnitt und einen Durchkontaktierungsverbindungsabschnitt umfasst, die elektrisch miteinander verbunden sind, wobei der erste Verbindungsabschnitt an einer Endfläche des mindestens einen zweiten Vorsprungs (22) angeordnet und elektrisch mit dem Stift (C2, C3) verbunden ist und sich der Durchkontaktierungsverbindungsabschnitt entlang der ersten Seite des zweiten Substrats (20) erstreckt;
eine leitfähige Durchkontaktierung (23), die an dem zweiten Substrat (20) vorgesehen ist, wobei die leitfähige Durchkontaktierung (23) mit einem leitfähigen Material versehen ist und elektrisch mit dem Durchkontaktierungsverbindungsabschnitt verbunden ist; und
ein Pad (81), das auf einer zweiten Seite des zweiten Substrats (20) vorgesehen und elektrisch mit der leitfähigen Durchkontaktierung (23) verbunden ist,
wobei in einer Draufsicht auf die Halbleitervorrichtung die leitfähige Durchkontaktierung (23) an einer Innenseite einer entsprechenden der mindestens einen zweiten Vorsprünge (22) angeordnet ist oder von einer entsprechenden der mindestens einen zweiten Vorsprünge (22) beabstandet ist, oder die leitfähige Durchkontaktierung (23) nicht mit einer Endfläche einer entsprechenden der mindestens einen zweiten Vorsprünge (22) befindet; und
wobei das zweite Substrat (20) mit einem vertieften Abschnitt versehen ist, der der leitfähigen Durchkontaktierung (23) auf der zweiten Seite des zweiten Substrats (20) entspricht, der vertiefte Abschnitt mit einem horizontalen Bodenabschnitt und geneigten Seitenwänden versehen ist, die leitfähige Durchkontaktierung (23) mit einem oberen Ende am horizontalen Bodenabschnitt versehen ist und das leitfähige Material in der leitfähigen Durchkontaktierung (23) mit einer leitfähigen Materialschicht des Pads (81) in Kontakt steht, das auf dem horizontalen Bodenabschnitt und den geneigten Seitenwänden des vertieften Abschnitts vorgesehen ist.

2. Halbleitervorrichtung nach Anspruch 1, **dadurch gekennzeichnet, dass** das Halbleitervorrichtung ferner umfasst:
eine Verbindungsschicht (71, 73), die auf einer Oberfläche des ringförmigen Stützvorsprungs (21) vorgesehen ist, wobei die Verbindungsschicht (71, 73) elektrisch von der Leiterschicht (70, 72) isoliert ist.

3. Halbleitervorrichtung nach Anspruch 1 oder 2, **dadurch gekennzeichnet, dass** der mindestens eine zweite Vorsprung (22) eine Vielzahl von voneinander beabstandeten zweiten Vorsprüngen umfasst und mindestens einer der Vielzahl von zweiten Vorsprüngen integral mit dem ringförmigen Stützvorsprung (21) ausgebildet ist; oder
mindestens einer der mindestens einen zweiten Vorsprünge (22) eine Vielzahl von voneinander beabstandeten Untervorsprüngen umfasst.

4. Halbleitervorrichtung nach Anspruch 1 oder 2, **dadurch gekennzeichnet, dass** mindestens ein Pin (C3), der dem mindestens einen zweiten Vorsprung (22) entspricht, eine L-förmige Kontaktfläche (D3) aufweist, die L-förmige Kontaktfläche (D3) eine kürzeste Seite mit einer Länge von nicht mehr als 50 µm aufweist, und alle Seiten der L-förmigen Kontaktfläche (D3) Längen von nicht weniger als 5 µm aufweisen; oder
mindestens ein Stift (C2), der dem mindestens einen zweiten Vorsprung (22) entspricht, eine rechteckige Kontaktfläche (D2) aufweist, wobei die rechteckige Kontaktfläche (D2) eine kürzeste Seite mit einer Länge von nicht mehr als 50 µm aufweist und alle Seiten der rechteckigen Kontaktfläche (D2) Längen von nicht weniger als 5 µm aufweisen.

5. Halbleitervorrichtung nach einem der Ansprüche 1 bis 4, **dadurch gekennzeichnet, dass** das Halbleitervorrichtung ferner eine Lötkugel (90) umfasst, die auf der zweiten Seite des zweiten Substrats (20) vorgesehen ist, und dass das Pad (81) und die Lötkugel (90) elektrisch miteinander verbunden sind.

6. Halbleitervorrichtung nach Anspruch 5, **dadurch gekennzeichnet, dass** die leitfähige Durchkontaktierung (23) in einer Dickenrichtung des zweiten Substrats (20) durch das zweite Substrat (20) hindurch verläuft.

7. Halbleitervorrichtung nach Anspruch 6, **dadurch gekennzeichnet, dass** eine Schutzschicht (82, 83) an einer oder mehreren Seiten der leitfähigen Durchkontaktierung (23) vorgesehen ist, wo sich eines oder beide Enden der leitfähigen Durchkontaktierung (23) befinden.

8. Halbleitervorrichtung nach Anspruch 1, **dadurch gekennzeichnet, dass** die geneigten Seitenwände mit einem abgestuften Abschnitt versehen sind; oder
eine Schutzschicht (83) an einer Seite vorgesehen ist, an der sich ein unteres Ende der leitfähigen Durchkontaktierung (23) befindet.

9. Halbleitervorrichtung nach Anspruch 1, **dadurch gekennzeichnet, dass** sich die Lötkugel (90) innerhalb des vertieften Abschnitts befindet; oder
der vertiefte Abschnitt eine Tiefe aufweist, die größer ist als die Hälfte einer Dicke (H1) des zweiten Substrats (20).

10. Elektronisches Gerät, das die Halbleitervorrichtung nach einem der Ansprüche 1 bis 9 umfasst.

11. Verfahren zur Herstellung einer Halbleitervorrichtung, umfassend:
Bereitstellen eines ersten Substrats (10) und eines zweiten Substrats (20), die einander gegenüberliegen, und Bereitstellen eines ringförmigen Stützvorsprungs (21) zwischen dem ersten Substrat (10) und dem zweiten Substrat (20), wobei der ringförmige Stützvorsprung (21), eine erste Seite des ersten Substrats (10) und eine erste Seite des zweiten Substrats (20) einen Aufnahmeraum definieren;
Bereitstellen eines Halbleiterelements in dem Aufnahmeraum, wobei das Halbleiterelement auf dem ersten Substrat (10) angeordnet und mit einem Pin (C2, C3) für eine elektrische Verbindung versehen ist;
Bereitstellen mindestens eines zweiten Vorsprungs (22) innerhalb des Aufnahmeraums, wobei der mindestens eine zweite Vorsprung (22) an einer Innenseite des ringförmigen Stützvorsprungs (21) angeordnet ist;
Bereitstellen einer Leiterschicht (70, 72) auf einer Oberfläche des mindestens einen zweiten Vorsprungs (22), wobei die Leiterschicht (70, 72) einen ersten Verbindungsabschnitt und einen Durchkontaktierungsverbindungsabschnitt umfasst, die elektrisch miteinander verbunden sind, wobei der erste Verbindungsabschnitt an einer Endfläche des mindestens einen zweiten Vorsprungs (22) angeordnet und elektrisch mit dem Stift (C2, C3) verbunden ist und sich der Durchkontaktierungsverbindungsabschnitt entlang der ersten Seite des zweiten Substrats (20) erstreckt; und
Bereitstellen einer leitfähigen Durchkontaktierung (23) an dem zweiten Substrat (20), wobei die leitfähige Durchkontaktierung (23) mit einem leitfähigen Material versehen ist und elektrisch mit dem Durchkontaktierungsverbindungsabschnitt verbunden ist,
wobei in einer Draufsicht auf die Halbleitervorrichtung die leitfähige Durchkontaktierung (23) an einer Innenseite eines entsprechenden der mindestens einen zweiten Vorsprünge (22) angeordnet ist oder von einem entsprechenden der mindestens einen zweiten Vorsprünge (22) beabstandet ist, oder die leitfähige Durchkontaktierung (23) nicht mit einer Endfläche eines entsprechenden der mindestens einen zweiten Vorsprünge (22) übereinstimmt; und
wobei das Bereitstellen der leitfähigen Durchkontaktierung (23) in dem zweiten Substrat (20) umfasst:
Bearbeiten eines Sacklochs auf der ersten Seite des zweiten Substrats (20), wobei das Sackloch eine Tiefe von nicht weniger als der Hälfte einer Dicke (H1) des zweiten Substrats (20) aufweist;
Füllen des Blindlochs mit dem leitfähigen Material;
Bearbeiten eines vertieften Abschnitts auf einer zweiten Seite des zweiten Substrats (20), wobei der vertiefte Abschnitt eine Tiefe von nicht weniger als der Hälfte der Dicke (H1) des zweiten Substrats (20) aufweist und die zweite Seite des zweiten Substrats (20) der ersten Seite des zweiten Substrats (20) gegenüberliegt; und
Bereitstellen einer leitfähigen Materialschicht innerhalb des vertieften Abschnitts, wobei die leitfähige Materialschicht elektrisch mit dem leitfähigen Material in dem Sackloch verbunden ist.

## Revendications

1. Dispositif à semi-conducteur, comprenant:
un premier substrat (10);
un deuxième substrat (20) opposé au premier substrat (10), un espace de logement étant prévu entre le premier substrat (10) et le deuxième substrat (20);
un élément semi-conducteur prévu dans l'espace de logement et disposé sur le premier substrat (10), l'élément semi-conducteur étant muni d'une broche (C2, C3) pour la connexion électrique;
une saillie de support annulaire (21) prévue entre le premier substrat (10) et le deuxième substrat (20), la saillie de support annulaire (21), un premier côté du premier substrat (10) et un premier côté du deuxième substrat (20) définissant l'espace de logement;
au moins une deuxième saillie (22) prévue sur un côté intérieur de la saillie de support annulaire (21) et disposée à l'intérieur de l'espace de logement;
une couche conductrice (70, 72) prévue sur une surface de la au moins une deuxième saillie (22), la couche conductrice (70, 72) comprenant une première partie de connexion et une partie de connexion via connectées électriquement l'une à l'autre, la première partie de connexion étant disposée au niveau d'une surface d'extrémité de la au moins une deuxième saillie (22) et connectée électriquement à la broche (C2, C3), et la partie de connexion via s'étendant le long du premier côté du deuxième substrat (20);
un via conducteur (23) prévu au niveau du deuxième substrat (20), le via conducteur (23) étant pourvu d'un matériau conducteur à l'intérieur et étant connecté électriquement à la partie de connexion de via; et
un plot (81) prévu sur un deuxième côté du deuxième substrat (20) et connecté électriquement au via conducteur (23),
dans lequel, dans une vue de dessus du dispositif à semi-conducteur, le via conducteur (23) est situé sur un côté intérieur d'une saillie correspondante parmi au moins une deuxième saillie (22) ou est espacé d'une saillie correspondante parmi au moins une deuxième saillie (22), ou le via conducteur (23) ne coïncide pas avec une surface d'extrémité d'une saillie correspondante parmi au moins une deuxième saillie (22); et
dans lequel le deuxième substrat (20) est muni d'une partie en retrait correspondant au via conducteur (23) sur le deuxième côté du deuxième substrat (20), la partie en retrait est pourvue d'une partie inférieure horizontale et de parois latérales inclinées, le trou d'interconnexion conducteur (23) est pourvu d'une extrémité supérieure au niveau de la partie inférieure horizontale, et le matériau conducteur dans le trou d'interconnexion conducteur (23) est en contact avec une couche de matériau conducteur du plot (81) prévu sur la partie inférieure horizontale et les parois latérales inclinées de la partie en retrait.

2. Dispositif à semi-conducteur selon la revendication 1, **caractérisé en ce que** le dispositif à semi-conducteur comprend en outre:
une couche de liaison (71, 73) prévue sur une surface de la saillie de support annulaire (21), la couche de liaison (71, 73) étant isolée électriquement de la couche conductrice (70, 72).

3. Dispositif à semi-conducteur selon la revendication 1 ou 2, **caractérisé en ce que** la au moins une deuxième saillie (22) comprend une pluralité de deuxièmes saillies espacées les unes des autres, et au moins une de la pluralité de deuxièmes saillies est formée d'un seul tenant avec la saillie de support annulaire (21); ou
au moins l'une des au moins une deuxième saillie (22) comprend une pluralité de sous-saillies espacées les unes des autres.

4. Dispositif à semi-conducteur selon la revendication 1 ou 2, **caractérisé en ce que** au moins une broche (C3) correspondant à au moins une deuxième saillie (22) présente une surface de contact en forme de L (D3), la surface de contact en forme de L (D3) a un côté le plus court dont la longueur n'est pas supérieure à 50 µm, et tous les côtés de la surface de contact en forme de L (D3) ont des longueurs qui ne sont pas inférieures à 5 µm; ou
au moins une broche (C2) correspondant à au moins une deuxième saillie (22) a une surface de contact rectangulaire (D2), la surface de contact rectangulaire (D2) a un côté le plus court dont la longueur n'est pas supérieure à 50 µm, et tous les côtés de la surface de contact rectangulaire (D2) ont des longueurs qui ne sont pas inférieures à 5 µm.

5. Dispositif à semi-conducteur selon l'une quelconque des revendications 1 à 4, **caractérisé en ce qu'**, le dispositif à semi-conducteur comprend en outre une bille de soudure (90) prévue sur le deuxième côté du deuxième substrat (20), et le plot (81) et la bille de soudure (90) sont connectés électriquement l'un à l'autre.

6. Dispositif à semi-conducteur selon la revendication 5, **caractérisé en ce que** le trou d'interconnexion conducteur (23) traverse le deuxième substrat (20) dans le sens de l'épaisseur du deuxième substrat (20).

7. Dispositif à semi-conducteur selon la revendication 6, **caractérisé en ce qu'**une couche protectrice (82, 83) est prévue sur un ou plusieurs côtés du trou d'interconnexion conducteur (23) où se trouvent l'une ou les deux extrémités du trou d'interconnexion conducteur (23).

8. Dispositif à semi-conducteur selon la revendication 1, **caractérisé en ce que** les parois latérales inclinées sont pourvues d'une partie en gradins; ou
une couche protectrice (83) est prévue sur un côté où se trouve une extrémité inférieure du trou d'interconnexion conducteur (23).

9. Dispositif à semi-conducteur selon la revendication 1, **caractérisé en ce que** la bille de soudure (90) est située à l'intérieur de la partie en retrait; ou
la partie en retrait a une profondeur supérieure à la moitié de l'épaisseur (H1) du deuxième substrat (20).

10. Dispositif électronique, comprenant le dispositif à semi-conducteur selon l'une quelconque des revendications 1 à 9.

11. Procédé de fabrication d'un dispositif à semi-conducteur, comprenant:
la fourniture d'un premier substrat (10) et d'un deuxième substrat (20) opposés l'un à l'autre et la fourniture d'une saillie de support annulaire (21) entre le premier substrat (10) et le deuxième substrat (20), la saillie de support annulaire (21), un premier côté du premier substrat (10) et un premier côté du deuxième substrat (20) définissant un espace de logement;
la mise en place d'un élément semi-conducteur dans l'espace de logement, l'élément semi-conducteur étant disposé sur le premier substrat (10) et muni d'une broche (C2, C3) pour la connexion électrique;
fournir au moins une deuxième saillie (22) à l'intérieur de l'espace de logement, la au moins une deuxième saillie (22) étant disposée sur un côté intérieur de la saillie de support annulaire (21);
fournir une couche conductrice (70, 72) sur une surface de la au moins une deuxième saillie (22), la couche conductrice (70, 72) comprenant une première partie de connexion et une partie de connexion via connectées électriquement l'une à l'autre, la première partie de connexion étant disposée au niveau d'une surface d'extrémité de la au moins une deuxième saillie (22) et connectée électriquement à la broche (C2, C3), et la partie de connexion via s'étendant le long du premier côté du deuxième substrat (20); et
fournir un via conducteur (23) au niveau du deuxième substrat (20), le via conducteur (23) étant pourvu d'un matériau conducteur à l'intérieur et connecté électriquement à la partie de connexion de via,
dans lequel, dans une vue de dessus du dispositif à semi-conducteur, le via conducteur (23) est situé sur un côté intérieur d'une saillie correspondante parmi les au moins une deuxième saillie (22) ou est espacé d'une saillie correspondante parmi les au moins une deuxième saillie (22), ou le via conducteur (23) ne coïncide pas avec une surface d'extrémité d'une saillie correspondante parmi les au moins une deuxième saillie (22); et
dans lequel la fourniture du trou d'interconnexion conducteur (23) dans le deuxième substrat (20) comprend:
le traitement d'un trou borgne sur le premier côté du deuxième substrat (20), le trou borgne ayant une profondeur au moins égale à la moitié de l'épaisseur (H1) du deuxième substrat (20);
remplir le trou borgne avec le matériau conducteur;
traiter une partie en retrait sur un deuxième côté du deuxième substrat (20), la partie en retrait ayant une profondeur qui n'est pas inférieure à la moitié de l'épaisseur (H1) du deuxième substrat (20), et le deuxième côté du deuxième substrat (20) étant opposé au premier côté du deuxième substrat (20); et
fournir une couche de matériau conducteur à l'intérieur de la partie en retrait, la couche de matériau conducteur étant connectée électriquement au matériau conducteur dans le trou borgne.
